# EUROPEAN PATENT SPECIFICATION

(11) **EP 4 024 375 B1**
(45) Date of publication and mention of the grant of the patent: **27.09.2023**
(21) Application number: 20877805.0
(22) Date of filing: 12.10.2020
(51) Int. Cl.: G09F 9/30

(54) **ELECTRONIC DEVICE**
ELEKTRONISCHE VORRICHTUNG
DISPOSITIF ÉLECTRONIQUE

(30) Priority: 15.10.2019 CN 201910976196; 31.07.2020 CN 202010756865
(43) Date of publication of application: 06.07.2022
(73) Proprietor: GUANGDONG OPPO MOBILE TELECOMMUNICATIONS CORP., LTD., Dongguan, Guangdong 523860 (CN)
(72) Inventor: ZHOU, Youwen, Dongguan, Guangdong 523860 (CN)
(74) Representative: Thorniley, Peter
(86) International application number: PCT/CN2020/120377
(87) International publication number: WO 2021/073475

(56) References cited:
- CN-A- 105 786 124
- CN-A- 106 157 816
- CN-A- 107 545 849
- CN-A- 108 519 795
- CN-A- 110 033 707
- CN-A- 110 047 387
- CN-A- 110 599 912
- KR-B1- 100 973 299
- US-A1- 2018 341 142

## Description

### FIELD

The present disclosure relates to the technical field of electronic products, and particularly, to an electronic device.

### BACKGROUND

Generally, a display screen of an electronic device, such as a smart phone and a tablet computer, has a relatively fixed size. The electronic device adopting a large-size display screen has a poor portability, while the electronic device employing a small-size display screen has relatively poor use experience. It is difficult to balance the portability and the use experience of the electronic devices. KR100973299B 1 provides a slimmed slide elastic module for a portable terminal, to reduce the total width of an elastic module and the space occupation of the elastic module. CN110033707A and CN108519795A disclose related display devices.

### SUMMARY

In this regard, it is urgent to provide an electronic device.

An electronic device includes a housing assembly, a tension assembly connected to the housing assembly, and a flexible screen module. The housing assembly includes a first housing, and a second housing connected to the first housing. The first housing has a first supporting surface, the second housing has a second supporting surface, and the first supporting surface is flush with the second supporting surface. The flexible screen module includes a fixed end, and a free end opposite to the fixed end. The fixed end is connected to the first housing and supported by the first supporting surface, the free end bypasses an end of the second housing facing away from the first housing and extends into the housing assembly, and the free end is connected to the tension assembly. The first housing is movable relative to the second housing to enable at least a part of the flexible screen module to unfold on the second supporting surface or to retract into the housing assembly. The tension assembly includes an elastic member and a movable member. The second housing, the free end, and the elastic member are connected to the movable member. The elastic member is connected to the second housing. The free end has a first slideway defined therein. One end of the movable member is rotatably connected to the second housing. The movable member has a limit column provided on the other end thereof and disposed in and penetrating through the first slideway. In the process of the flexible screen module unfolding from the housing assembly, the movable member is driven by the flexible screen module to swing relative to the second housing and enable the limit column to slide along the first slideway. In the process of the flexible screen module retracting into the housing assembly, the movable member is driven by the elastic member to swing and to restore.

### BRIEF DESCRIPTION OF DRAWINGS

In order to clearly explain technical solutions of embodiments of the present disclosure or technical solutions in the prior art, drawings used in the embodiments or in prior art are briefly described below. Obviously, the drawings described below merely illustrate some embodiments of the present disclosure. Based on these drawings, drawings of other embodiments can be obtained by those skilled in the art without paying creative efforts.
Fig. 1 is a front view of an electronic device according to an embodiment.
Fig. 2 is a bottom view of the electronic device illustrated in Fig. 1.
Fig.3 is a cross-sectional view of the electronic device illustrated in Fig. 1 in a state.
Fig. 4 is a cross-sectional view of the electronic device illustrated in FIG. 1 in another state.
Fig. 5 is an exploded view of the electronic device illustrated in Fig. 4.
Fig. 6 is a schematic diagram of the electronic device illustrated in Fig. 4 after part of the structure is removed.
Fig. 7 is a schematic diagram of the electronic device illustrated in Fig. 3 after part of the structure is removed.
Fig. 8 is a schematic diagram of the electronic device illustrated in Fig. 7 from another perspective.
Fig. 9 is a schematic diagram of the electronic device illustrated in Fig. 8 in another state.
Fig. 10 is an exploded view of the electronic device illustrated in Fig. 1.
Fig. 11 is an exploded view of a second housing of the electronic device illustrated in Fig. 10.
Fig. 12 is a cross-sectional view of the electronic device illustrated in Fig. 9.
Fig. 13 is an enlarged schematic diagram of portion A of the electronic device illustrated in Fig. 12.
Fig. 14 is an exploded view of a first housing of the electronic device illustrated in Fig. 10.
Fig. 15 is an enlarged schematic view of portion B of the first housing of the electronic device illustrated in Fig. 14.
Fig. 16 is an enlarged schematic diagram of portion C of the second housing of the electronic device illustrated in Fig. 11.
Fig. 17 is a schematic diagram of a flexible screen module according to an embodiment.
Fig. 18 is an exploded view of the flexible screen module of the electronic device illustrated in Fig. 17.
Fig. 19 is an enlarged schematic diagram of portion D of the flexible screen module of the electronic device illustrated in Fig. 17.
Fig. 20 is a cross-sectional view of the electronic device illustrated in Fig. 7.
Fig. 21 is a cross-sectional view of the electronic device illustrated in Fig. 9.
Fig. 22 is an exploded view of a tension assembly, a support plate, and a cover plate of the electronic device illustrated in Fig. 10.
Fig. 23 is an exploded view of the tension assembly, the support plate and the cover plate of the electronic device illustrated in Fig. 22 from another perspective.
Fig. 24 is a cross-sectional view of an electronic device according to another embodiment.
Fig. 25 is a schematic diagram of an electronic device according to yet another embodiment.
Fig. 26 is an exploded view of the electronic device illustrated in Fig. 25.

### Reference signs:

100. electronic device; 10. housing assembly; 12. first housing
12a. first supporting surface; 12b. first pushing portion; 121. first bracket
121a. sliding groove; 122. back cover; 123. first support member
123a. limit groove; 123b. bump; 123c. guide groove
124. decoration member; 125. slot; 14. second housing
14a. second supporting surface; 14b. first channel; 14c. second slideway
14d. second channel; 14e. guide recess; 14f end surface
141. second bracket; 142. end cover; 143. second support member
143a. first protrusion; 143b. connection portion; 143c. limit portion
143d. guide protrusion bar a1. arc surface; 144. side cover
145. positioning protrusion; 146. PVC film; 147. rotation shaft
148. support plate; 148a. second protrusion; 149. cover plate
16. receiving space; 20. flexible screen module; 20a. fixed end
20b. free end; 20c. second pushing portion; 21. flexible display
21a. first screen body; 21b. second screen body; 23. reinforcement layer
25. support plate; 251. first plate; 253. second plate
253a. strip plate; 27. slide rail; 27a. first slideway
30. guide member; 30a. groove; 40. circuit board
50. battery; 60. tension assembly; 61. elastic member
63. movable member; 63a. limit column; 65. pin
67. transmission body; 71. pressing plate; 73. double-sided adhesive

### DESCRIPTION OF EMBODIMENTS

In order to facilitate the understanding of the present disclosure, the present disclosure will be described in detail below with reference to the relevant drawings. The preferred embodiments of the present disclosure are illustrated in the drawings. However, the present disclosure can be implemented in many different forms and is not limited to the embodiments described herein. On the contrary, these embodiments are provided to explain the present disclosure thoroughly and comprehensively.

As used herein, "terminal device" refers to, but is not limited to, an apparatus capable of receiving and/or transmitting communication signals and being connected via any one or several of the following connection methods.
(1) Connection via wired lines, such as a public switched telephone network (PSTN), a digital subscriber line (DSL), a digital cable, and a direct cable connection.
(2) Connection via a wireless interface, such as a cellular network, a wireless local area network (WLAN), a digital TV network such as a DVB-H network, a satellite network, an AM-FM broadcast transmitter.

A terminal device configured to communicate through a wireless interface may be referred to as a "mobile terminal". Examples of the mobile terminal include, but are not limited to, the following electronic devices:
(1) a satellite phone or a cellular phone;
(2) a personal communication system (PCS) terminal combining a cellular radio phone with data processing, fax, and data communication functions;
(3) a radio phone, a pager, Internet/Intranet access, a Web browser, a notebook, a calendar, a personal digital assistant (PDA) equipped with a global positioning system (GPS) receiver;
(4) a conventional laptop and/or palmtop receiver; and
(5) a conventional laptop and/or palmtop radio telephone transceiver, etc.

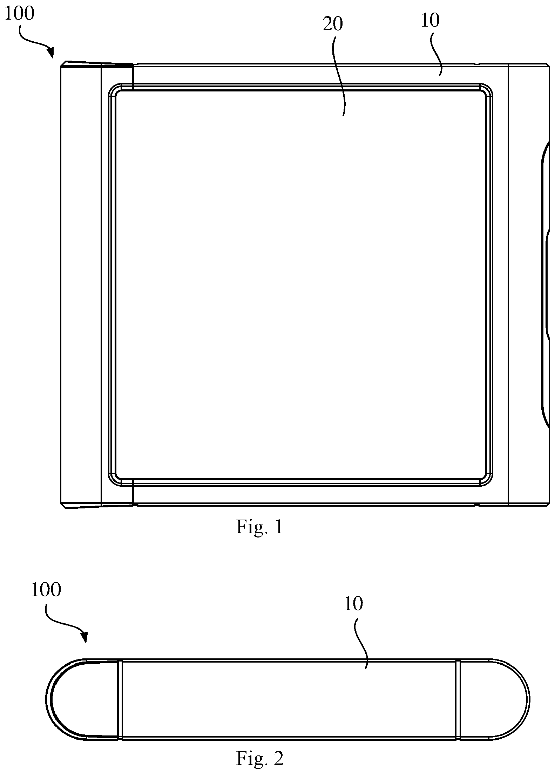

Referring to Fig. 1, Fig. 2, and Fig. 3, an electronic device 100 according to an embodiment includes a housing assembly 10, a flexible screen module 20, a guide member 30, a circuit board 40, and a battery 50. The housing assembly 10 has a hollow structure. The flexible screen module 20, the guide member 30, the circuit board 40, the battery 50, etc. can all be disposed in the housing assembly 10. The circuit board 40 is in communication connection with the flexible screen module 20, and the battery 50 can supply power to the flexible screen module 20 and electronic elements on the circuit board 40. Of course, the electronic device 100 may further include a camera module (not shown), the camera module is in communication connection with the circuit board 40, and the battery 50 can supply power to the camera module. It can be appreciated that the electronic device 100 in the embodiment of the present disclosure is, but not limited to, a mobile terminal such as a mobile phone and a tablet computer, or other portable electronic device. In the embodiments of the present disclosure, as an example for description, the electronic device 100 is a mobile phone.

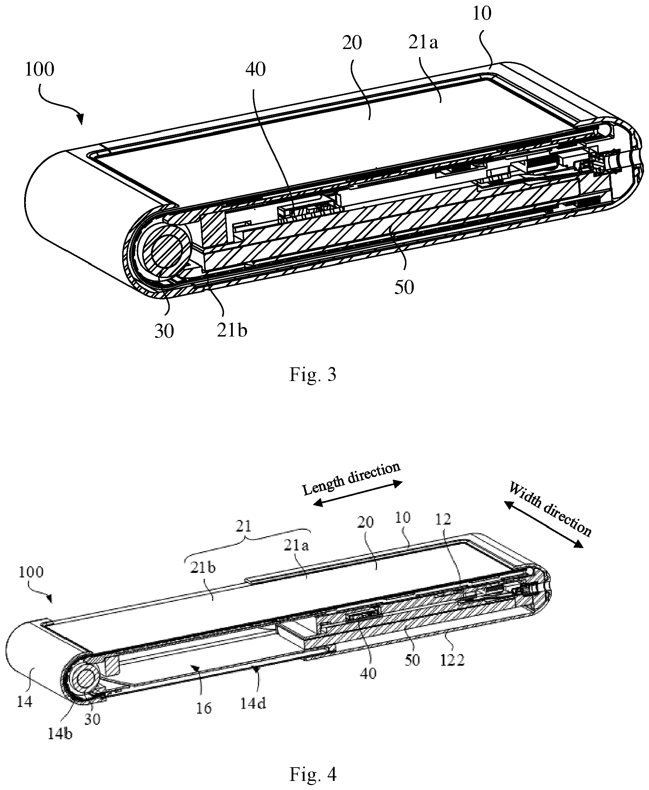

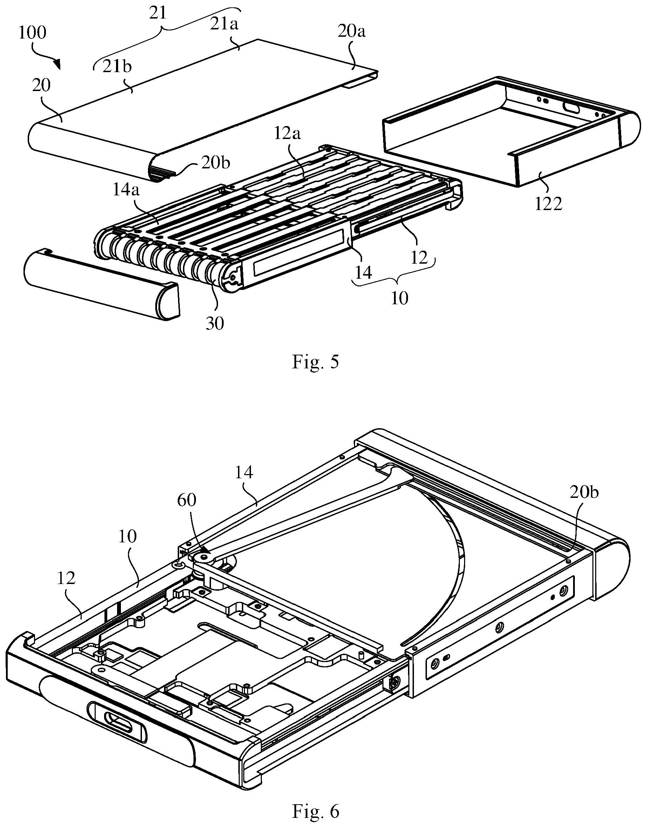

With reference to Fig. 4 and Fig. 5, in this embodiment of the present disclosure, the housing assembly 10 includes a first housing 12 and a second housing 14, and the second housing 14 and the first housing 12 are movable relative to each other. Specifically, in this embodiment, the second housing 14 and the first housing 12 are slidably connected to each other. In other words, the first housing 12 is slidable relative to the second housing 14. For example, the first housing 12 is slidable relative to the second housing 14 into a first position and a second position. With reference to Fig. 3, when the first housing 12 is at the first position, the electronic device 100 has a relatively small size to be portable. With reference to Fig. 4, when the first housing 12 is at the second position, the electronic device 100 can have a relatively large display area to improve the use experience of the electronic device 100. In this embodiment, an overall length of the electronic device 100 when the first housing 12 is at the second position is greater than that when the first housing 12 is at the first position. In this way, the exposed flexible screen module 20 can have a variable length. In other words, the electronic device 100 has a variable size in the length direction. In this embodiment, an external interface of the electronic device 100, such as a data cable socket, a charging cable socket, or an earphone socket, may be disposed at an end in the length direction. In other embodiments, an overall width of the electronic device 100 when the first housing 12 is at the second position may be greater than that when the first housing 12 is at the first position, so that the exposed flexible screen module 20 has a variable width. In other words, the electronic device 100 has a variable width in the width direction. In this embodiment, the external interface of the electronic device 100, such as a data cable socket, a charging cable socket, or an earphone socket, may be disposed at an end in the width direction.

Specifically, referring to Fig. 4 and Fig. 5, a receiving space 16 can be defined by the first housing 12 and the second housing 14. The receiving space 16 can be used to receive the guide member 30, the circuit board 40, the battery 50, and the like. The flexible screen module 20 includes a fixed end 20a, and a free end 20b opposite to the fixed end. The fixed end 20a is disposed on the first housing 12. At the first position, the flexible screen module 20 bypasses the guide member 30, and the free end 20b of the flexible screen module 20 is received in the housing assembly 10, such that a part of the flexible screen module 20 is hidden in the housing assembly 10 and may not be used for displaying. The first housing 12 may include a back cover 122, and a light-transmitting area may be disposed on a side where the back cover 122 is located. The part of the display module 20, which is received in the housing assembly 10 when the first housing 12 is at the first position, may also be used for displaying to expand the application scenarios of the electronic device 100. The light-transmitting area may be formed by transparent glass or an opening defined in the back cover 122. Once the first housing 12 slides into the second position relative to the second housing 14, at least the part of the flexible screen module 20 received in the housing assembly 10 is exposed. The exposed flexible screen module 20 can be used for displaying, enabling the electronic device 100 to have a relatively large display area, thereby improving the user experience.

The guide member 30 is disposed on the second housing 14. In a process of the first housing 12 sliding into the second position relative to the second housing 14, the guide member 30 can guide the flexible screen module 20 to be deformed and unfolded on the second housing 14. Specifically, the guide member 30 may be a rotating shaft structure with teeth, and the flexible screen module 20 is linked with the guide member 30 by means of engaging or the like. When the first housing 12 slides relative to the second housing 14, a part of the flexible screen module 20 engaging with the guide member 30 is driven by the guide member 30 to move and to be unfolded from or to retract into the housing assembly 10.

It can be understood that the guide member 30 may also be a round shaft without teeth. In the process of switching the first housing 12 from the first position to the second position, the part of the flexible screen module 20 attached to the guide member 30 is expanded by the guide member 30, allowing more part of the flexible screen modules 20 to be exposed to outside of the housing assembly 10 and to be in an unfolded and flat state. In some embodiments, the guide member 30 is rotatably disposed on the second housing 14. In the process of the flexible screen module 20 gradually unfolding, the guide member 30 can rotate with the movement of the flexible screen module 20. In other embodiments, the guide member 30 may be fixed on the second housing 14, and the guide member 30 has a smooth surface; and in the process of the flexible screen module 20 unfolding, the guide member 30 can slidably contact the flexible screen module 20 with its smooth surface. In other words, in such embodiments, the guide member 30 and the second housing 14 can be formed into one piece or welded, the guide member 30 can be regarded as a part of the second housing 14, and the free end 20b of the flexible screen module 20 bypasses an end of the second housing 14 facing away from the first housing 12 and extends into the housing assembly 10.

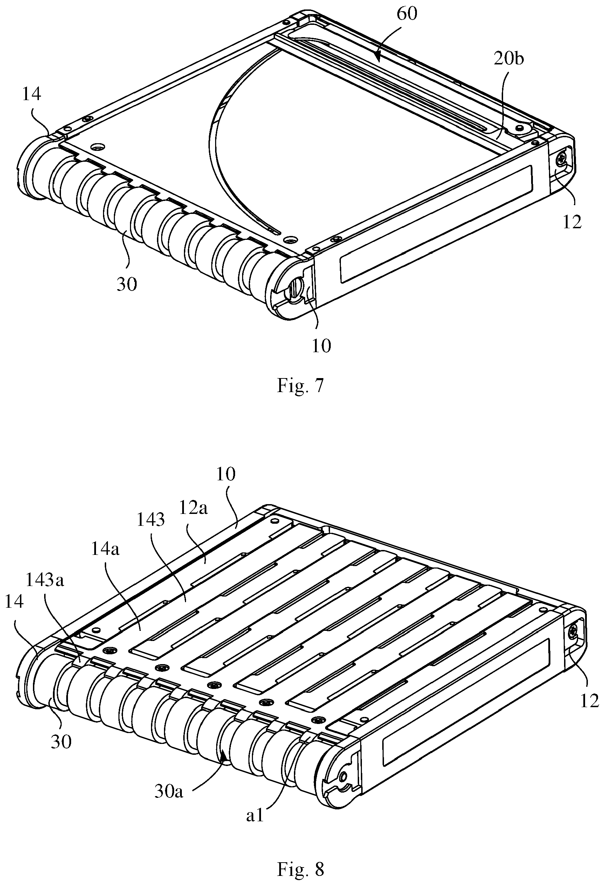

When the first housing 12 switches from the second position to the first position, the flexible screen module 20 can be driven by the guide member 30 to be retracted. Of course, referring to Fig. 6 and Fig. 7, the electronic device 100 may further include a tension assembly 60. The free end 20b of the flexible screen module 20 is linked with the tension assembly 60. In the process of the second housing 14 switching from the second position to the first position, the flexible screen module 20 is driven by the tension assembly 60 to restore, allowing the part of the flexible screen module 20 to retract into the housing assembly 10. After the flexible screen module 20 is retracted into the housing assembly 10, the electronic device 100 can have a relatively small size of appearance, thereby improving the portability of the electronic device 100.

In some embodiments, the electronic device 100 may further include a driving mechanism (not shown), the driving mechanism may be disposed in the housing assembly 10, the driving mechanism may be linked with the second housing 14 or the first housing 12 and configured to drive the first housing 12 to move relative to the second housing 14, so as to drive the flexible screen module 20 to be unfolded or retracted. It can be understood that the driving mechanism 40 may be omitted, and the user may directly and manually drive the relative movement between the first housing 12 and the second housing 14.

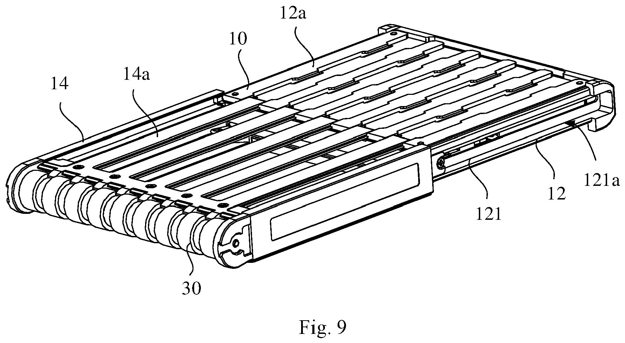

With reference to Fig. 8 and Fig. 9, the first housing 12 of the electronic device 100 has a first supporting surface 12a, and the second housing 14 has a second supporting surface 14a. In the process of the first housing 12 moving relative to the second housing 14, the first supporting surface 12a and the second supporting surface 14a are kept flush for supporting the flexible screen module 20, so that the flexible screen module 20 can be unfolded to be flat or retracted into the housing assembly 10. A first channel 14b (referring to Fig. 4) is defined by the guide member 30 and the second housing 14 and in communication with the receiving space 16, a part of the flexible screen module 20 is attached to the first supporting surface 12a and connected to the first housing 12, the other part of the flexible screen module 20 is attached to the guide member 30, passes through the first channel 14b, and extends into the housing assembly 10. During the movement of the first housing 12 relative to the second housing 14, the first supporting surface 12a moves relative to the second supporting surface 14a and drives the flexible screen module 20 located in the housing assembly 10 to enter or exit from the housing assembly 10 through the first channel 14b, and the flexible screen module 20 stretching out of the first channel 14b can be supported by the second supporting surface 14a. In the embodiments of the present disclosure, "flush" can be simply construed as two planes being disposed coplanar. Of course, considering engineering errors, "flush" should be understood as that the surfaces of the parts meet a predetermined flatness requirement and a predetermined parallelism requirement, rather than two planes being strictly coplanar.

Specifically, the flexible screen module 20 includes a flexible display screen 21 for displaying. The flexible display screen 21 includes a first screen body 21a, and a second screen body 21b connected to the first screen body 21a. In the present embodiment, the first screen body 21a and the second screen body 21b are an integrated structure. With reference to Fig. 3 and Fig. 4, the first screen body 21a and the second screen body 21b can be simply distinguished from each other in the following way: when the first housing 12 is at the first position, the first screen body 21a is a part of the flexible screen module 20 exposed to a side where the first supporting surface 12a is located, and the second screen body 21b is a part of the flexible screen module 20 received in the housing assembly 10.

A position of the first screen body 21a and a position of the first housing 12 are relatively fixed. For example, the first screen body 21a can be fixedly connected to the first housing 12 by means of bonding or threads. Of course, the first screen body 21a can be fixedly connected to the first housing 12 via other intermediate support structure, so as to more reliably position the first screen body 21a on the first housing 12. With reference to Fig. 5, the first housing 12 is movable relative to the second housing 14between the first position and the second position and drives the second supporting surface 14a to move relative to the first supporting surface 12a. At the first position, the screen body 21a is exposed and the first screen body 21a is supported by the first supporting surface 12a, and the second screen body 21b passes through the first channel 14b and extends into the housing assembly 10 to be approximately parallel to the first screen body 21a, as illustrated in Fig. 3. Of course, when the first housing 12 is at the first position, the second supporting surface 14a and the first supporting surface 12a can jointly support the first screen body 21a. With reference to Fig. 4 and Fig. 5, at the second position, at least a part of the second screen body 21b extends out of the first channel 14b and is supported by the second supporting surface 14a to expand a display area of the electronic device 100. It can be understood that other intermediate structural members may exist between the first supporting surface 12a and the first screen body 21a or between the second supporting surface 14a and the second screen body 21b, so that the first supporting surface 12a can support the first screen body 21a through the intermediate structural member, or the second supporting surface 14a can support the second screen body 21b through the intermediate structural member.

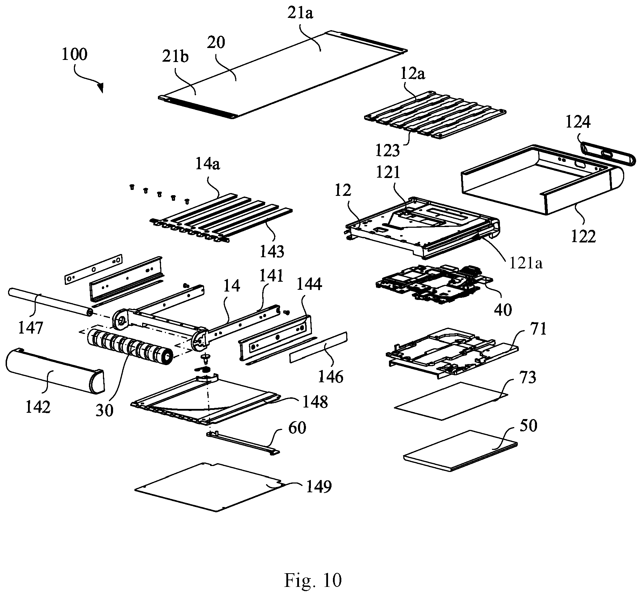

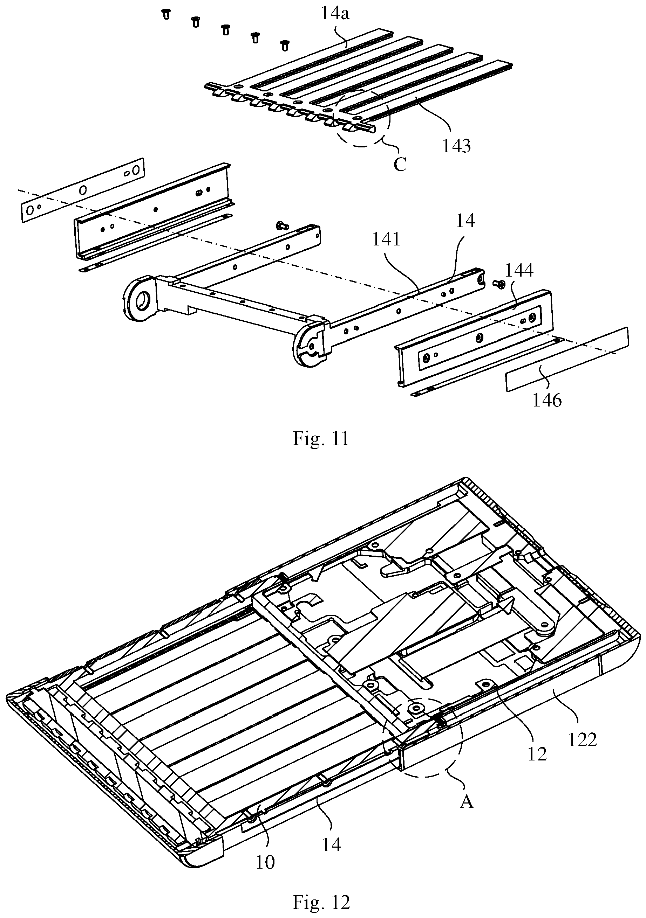

Referring to Fig. 10 and Fig. 11, the first housing 12 may include a first bracket 121, and a first support member 123 connected to the first bracket 121. The first support member123 has an approximate plate shape, and the first supporting surface 12a is located on the first support member 123. The back cover 122 is connected to the first bracket 121. In this embodiment, the first support member 123 is connected to the first bracket 121 by means of threaded fasteners. In other embodiments, the first support member 123 and the first bracket 121 may be formed into one piece. For example, the first support member 123 and the first bracket 121 may be formed by die casting. The second housing 14 may include a second bracket 141, and a second support member 143 connected to the second bracket 141. The second bracket 141 has substantially a U shape, the second support member 143 has an approximate plate shape, the second supporting surface 14a is located on the second support member 143, and the guide member 30 is connected to the second bracket 141. In this embodiment, the second support member 143 is connected to the second bracket 141 by means of threaded fasteners. In other embodiments, the second support member 143 and the second bracket 141 may be formed into one piece, for example, the second support member 143 and the second bracket 141 may be formed by die casting.

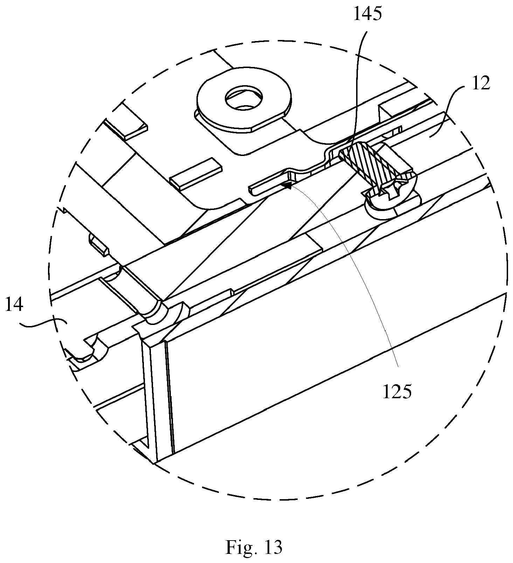

Furthermore, with reference to Fig. 9 and Fig. 10, in the embodiment of the present disclosure, sliding grooves 121a are defined on both sides of the first bracket 121, and the second bracket 141 is slidably disposed in the sliding grooves 121a, allowing the second housing 14 to slide smoothly on the first housing 12. Further, referring to Fig. 12 and Fig. 13, one of the second housing 14 and the first housing 12 has a positioning protrusion 145 provided thereon, and the other one of the first housing 12 and the second housing 14 has a slot defined therein. In the process of the first housing 12 moving relative to the second housing 14, the positioning protrusion 145 engages into the slot 125 to fix the first housing 12 to the second housing 14. In the embodiment of the present disclosure, the positioning protrusion 145 is formed by a bolt, the slot 125 is formed through a thin elastic sheet. The slot 125 is defined by fixedly connecting one of the second bracket 141 and the first bracket 121 to the elastic sheet, and the positioning protrusion 145 is defined by fixedly connecting the other one of the second bracket 141 and the first bracket 121 to the bolt. In the process of the first housing 12 moving relative to the second housing 14 to a specific position, the positioning protrusion 145 can enter the slot 125 to exert the positioning function, so as to maintain the flexible screen module 20 in an unfolded state. In some embodiments, one slot is provided and a position of the slot 125 corresponds to a state of the first housing 12 being at the second position, so as to more reliably position the first housing 12 with respect to the second housing 14, thereby maintaining the stable unfolded state of the flexible screen module 20. In other embodiments, more than two slots are provided, and the slots 125 are spaced apart from each other along a movement direction of the first housing 12 relative to the second housing 14, so as to maintain the stable unfolded state of the flexible screen module 20 at multiple specific positions, thereby expanding the application scenarios of the electronic device 100. For example, a plurality of intermediate positions may exist between the first position and the second position. In different intermediate positions, the flexible screen module 20 has different expanded areas, and the display area of the electronic device 100 has different sizes. In other embodiments, the positioning protrusion 145 and the slot 125 may be disposed in other positions, and the positioning protrusion 145 may adopt other structural forms such as an elastic column or an elastic thimble.

Furthermore, at the first position, the back cover 122 can better shield the second bracket 141 to prevent dust or liquid from entering the electronic device 100, thereby improving the waterproof and dustproof performance of the electronic device 100. Furthermore, in this embodiment, the battery 50 and the circuit board 40 are disposed on the first bracket 121 and covered by the back cover 122. Further, referring to Fig. 10, the electronic device 100 may include a pressing plate 71. The circuit board 40 is connected to a side of the first bracket 121 facing away from the first supporting surface 12a, and the pressing plate 71 is stacked on the circuit board 40 and detachably connected to the first bracket 121 through threaded fasteners. In this way, the pressing plate 71 is pressed against the circuit board 40 to reliably fix the circuit board 40 on the first bracket 121. The battery 50 can be fixedly connected to a side of the pressing plate 71 facing away from the circuit board 40 through a double-sided adhesive 73. Further, the first housing 12 may include a decorative member 124, and the decorative member 124 is fixedly connected to the back cover 122 through glue or threaded fasteners. In the embodiment of the present disclosure, the decorative member 124 is located at an end of the back cover 122 and is used to interact with an external interface structure, such as a data cable socket, an earphone socket, and the like, defined in the back cover 122.

Furthermore, the second housing 14 may include an end cover 142, and the end cover 142 may be fixedly connected to the second bracket 141 through a structure such as a threaded fastener or a buckle, and the first channel 14b is defined by the cover 142 together with the guide member 30. In the embodiment of the present disclosure, a position of the end cover 142 is opposite to a position of the decorative member 124, i.e., the end cover 142 is located at an end of the electronic device 100, and the decorative member 124 is located at the other end of the electronic device 100. Of course, the end cover 142 can be assembled with the guide member 30 as a component having the first channel 14b, which is then connected to the second bracket 141.

With reference to Fig. 11, the second housing 14 may further include a side cover 144 and a polyvinyl chloride (PVC) film 146. Two side covers 144 may be provided and both are fixedly connected to the second bracket 141 by means of screws. The two side covers 144 are respectively disposed on both sides of the second bracket 141 and cover a part of the second bracket 141 slidably engaging with a sliding groove 121a of the first bracket 121. Two PVC films 146 may be provided and correspond to the two side covers 144 in one-to-one correspondence. The PVC film 146 may be adhered to the side cover 144 and cover holes defined in the side cover 144 for threading screws and cover the screws disposed in and penetrating through the holes. In this way, the second housing 14 has a better appearance and integrity and prevents liquid or dust from entering the electronic device 100 from the second housing 14. After the end cover 142, the side cover 144, and the second bracket 141 are assembled and fixed, the side cover 144 can pass through the back cover 122 and enter and exit from the back cover 122 in the process of the first housing 12 moving relative to the second housing 14.

Referring to Fig. 10, in this embodiment, the guide member 30 is rotatably disposed on the second bracket 141. Specifically, the second housing 14 may include a rotation shaft 147 connected to the second bracket 141, and the cylindrical guide member 30 is sleeved on the rotation shaft 147 and rotatably fits with the rotation shaft 147. In some embodiments, the rotation shaft 147 is fixedly connected to the second bracket 141 by means of threaded fasteners. In other embodiments, the rotation shaft 147 may be welded to the second bracket 141 or formed into one piece with the second bracket 141. In a process of the flexible screen module 20 entering and exiting the housing assembly 10, the guide member 30 is attached to the flexible screen module 20 and can be driven by the flexible screen module 20, so as to guide the flexible screen module 20 to be bent and deformed. The cylindrical guide member 30 may have a relatively large outer diameter in order to satisfy the requirement of a limit bending radius of the flexible screen module 20. In combination with the structural configuration of the first channel 14b, the cylindrical guide member 30 can support and protect a bending part of the second screen body 21b, so as prevent the bending part of the second screen body 21b from being damaged, thereby prolonging the fatigue life of the flexible screen module 20. The rotatable guide member 30 may also reduce the frictional resistance in the process of the flexible screen module 20 entering and exiting from the first channel 14b, and reduce the abrasion on a surface of the flexible screen module 20 and on a surface of the guide member 30, thereby prolonging the service life of the electronic device 100.

It can be understood that the end cover 142 and the first channel 14b are not essential. When the end cover 142 and the first channel 14b are omitted, at the first position, the part of the flexible screen module 20 attached to the guide member 30 can be exposed and used for displaying, so as to expand the application scenarios of the electronic device 100.

Further, referring to Fig. 8, grooves 30a surrounding the guide member 30 are defined on the surface of the guide member 30, and the second support member 143 has first protrusions 143a provided at an end thereof close to the guide member 30. The first protrusions 143a extend into the grooves 30a, the first protrusions 143a may not contact groove walls of the grooves 30a to avoid interference with rotation of the guide member 30. Further, the first protrusion 143a may have an arc surface a1 tangent to the second supporting surface 14a, the arc surface a1 and the second supporting surface 14a are located on a same side of the second supporting member 143, and the arc surface a1 extends into the groove 30a. In a process of retracting the second screen body 21b into the housing assembly 10, the above-mentioned structure enable the second screen body 21b to move smoothly from the second supporting surface 14a to the guide member 30, thereby preventing the second screen body 21b from being bent and causing a jam at a gap between the second supporting member 143 and the guide member 30. Of course, the first protrusions 143a can guide the flexible screen module 20 in the process of the second screen body 21b entering and exiting the housing assembly 10, thereby enabling the flexible screen module 20 to be unfolded to be flat or to be smoothly retracted into the housing assembly 10. It can be understood that, by providing the first protrusions 143a, the requirements on the gap between the second support member 143 and the guide member 30 can be appropriately reduced, and accordingly, the requirements on assembly accuracy can be reduced and the assembly efficiency can be improved. It can be understood that the arc surface a1 of the first protrusion 143a is not essential. For example, a surface of the first protrusion 143a, which is on the same side as the second supporting surface 14a, may be located on the same plane as the second supporting surface 14a, and this plane can be tangent to a cylindrical surface of the guide member 30, thereby allowing the flexible screen module 20 to be better attached to the surface of the guide member 30 and deformed through the guiding of the guide member 30.

In the embodiment of the present disclosure, at least two grooves 30a are provided and the grooves 30a are spaced apart from each other along an axial direction of the guide member 30, and at least two first protrusions 143a are provided and correspond to the at least two grooves 30a in one-to-one correspondence. By providing the plurality of first protrusions 143a, the flexible screen module 20 can be relatively stable in the process of entering and exiting from the first channel 14b, and prevent being stuck.

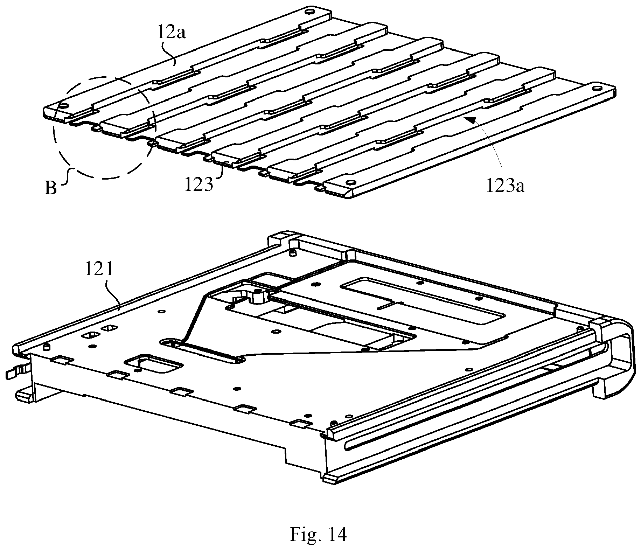

Referring to Fig. 14, Fig. 15 and Fig. 16, a plurality of limit grooves 123a spaced apart from each other is defined in the first support member 123; the second support member 143 is substantially comb-shaped, and the second support member 143 includes a connection portion 143b and a plurality of limit portions 143c extending from the connection portion 143b. The plurality of limit portions 143c has at least a part of the second supporting surface 14a. In other words, the plurality of limit portions 143c may have all the second supporting surface 14a, that is, the plurality of limit portions 143c is used to support the flexible screen module 20. The plurality of limit portions 143c may have a part of the second supporting surface 14a, and the connection portion 143b has the other part of the second supporting surface 14a, that is, a part of a surface of the connection portion 143b and a part of a surface of the plurality of limit portions 143c are configured to support the second supporting surface 14a of the flexible screen module 20. The limit portions 143c are disposed on an end of the connection portion 143b facing away from the first protrusions 143a, that is, the limit portions 143c are disposed on an end of the connection portion 143b close to the fixed end 20a. The limit portions 143c correspond to the limit grooves 123a in one-to-one correspondence, and in the process of the first housing 12 moving relative to the second housing 14, the limit portion 143c moves in a corresponding one limit groove 123a.

Due to the presence of the sliding grooves 121a defined on both sides of the first bracket 121 and slidable fitting with the second bracket 141, in the process of the first housing 12 moving relative to the second housing 14, the limit portions 143c and groove walls of the limit grooves 123a may not be in contact to reduce the frictional resistance between the second support member 143 and the first support member 123. Of course, the limit portion 143c can slidably fit in the limit groove 123a, and thus the groove wall of the limit groove 123a can be used to limit and guide the movement of the limit portion 143c, and to guide and limit the sliding of the first housing 12 relative to the second housing 14; and in this embodiment, the first bracket 121 can slidably fit with the second bracket 141 without providing the sliding grooves 121a on both sides of the first bracket 121.

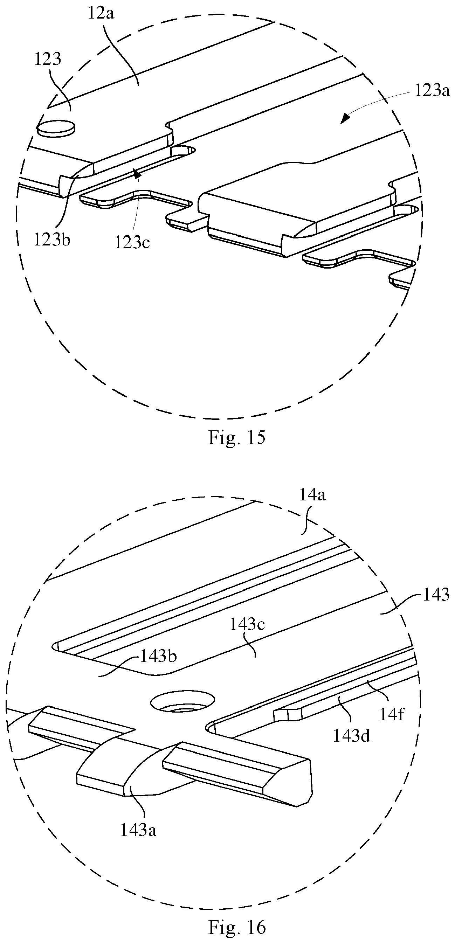

Further, referring to Fig. 16, each limit portion 143c may have a guide protrusion bar 143d provided at an edge thereof and extending along a moving direction of the first housing 12. The guide protrusion 143d has an end surface 14f at the same side as the second supporting surface 14a, and a height difference exists between the end surface 14f and the second supporting surface 14a. In other words, the guide protrusion bar 143d and the limit portion 143c form a stepped structure. With reference to Fig. 15, the limit groove 123a is a sinking groove and extends along a moving direction of the second housing 14. The limit groove 123a has a lug 123b provided at a side wall thereof and spaced apart from a bottom of the limit groove, so as to define a guide groove 123c between the lug 123b and the bottom of the limit groove 123a. The guide protrusion bar 143d is disposed in and penetrates through the guide groove 123c. The position of the second support member 143 and the first support member 123 can be limited in a thickness direction of the electronic device 100 by means of the engagement between the guide protrusion bar 143d and the guide groove 123c, thereby preventing the second support member 143 from moving out of the limit groove 123a, enabling the second supporting surface 14a and the first supporting surface 12a to stably support the flexible screen module 20.

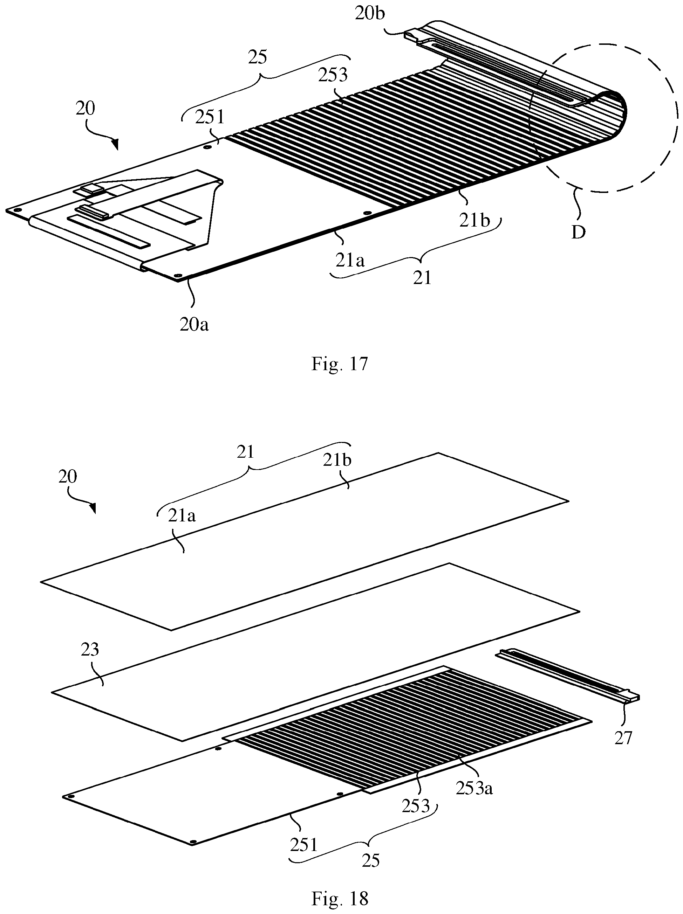

Referring to Fig. 17 and Fig. 18, in the embodiment of the present disclosure, the flexible screen module 20 further includes a reinforcement layer 23 and a support plate 25, and the flexible display screen 21, the reinforcement layer 23 and the support plate 25 are sequentially stacked. A high-viscosity adhesive can be disposed between the flexible display screen 21 and the reinforcement layer 23 as well as between the reinforcement layer 23 and the support plate 25, to reliably fix the flexible display screen 21, the reinforcement layer 23, and the support plate 25. Apart of the support plate 25 is attached to the first supporting surface 12a and connected to the first housing 12, and the other part of the support plate 25 is attached to the guide member 30, passes through the first channel 14b, and extends into the housing assembly 10. Further, the support plate 25 includes a first plate 251 and a second plate 253. The first plate 251 is stacked on the reinforcement layer 23 and corresponds to a position of the first screen body 21a, and the second plate 253 is stacked on the reinforcement layer 23 and corresponds to a position of the second screen body 21b. The second screen body 21b and the first screen body 21a constitute part or all of the flexible display screen 21.

The reinforcement layer 23 may be a polyimide film (PI film), and the reinforcement layer 23 covers the second screen body 21b and the first screen body 21a. The reinforcement layer 23 has excellent high-temperature resistance and low-temperature resistance, electrical insulation, cohesiveness and radiation resistance, and thus the reinforcement layer 23 can guide the deformation of the flexible display screen 21 and play a better role in protecting and supporting the flexible display screen 21. In other embodiments, the reinforcement layer 23 is made of other relatively flexible materials, such as polyester or polyfluoride, so as to utilize the flexibility of the reinforcement layer 23 to guide the deformation of the flexible display screen 21 and to play a better role in protecting and supporting the flexible display 21.

Further, the first plate 251 may have higher rigidity, and the shape of the first plate 251 remains unchanged along the movement of the first housing 12 relative to the second housing 14. Further, the first plate 251 may be fixedly connected to the first housing 12. For example, the first plate 251 may be connected to the first support member 123 or the first bracket 121 by bonding or by means of threaded fasteners. The second plate 253 may include a plurality of strip plates 253a space apart from each other, and a longitudinal extension direction of the strip plates 253a is parallel to an axial direction of the guide member 30. In the process of the second screen body 21b entering and exiting the housing assembly 10, the strip plates 253a can be well attached to the surface of the guide member 30, so as to guide the deformation of the flexible screen module 20 and provide the flexible screen module 20 with appropriate structural rigidity. The second plate 253 may have a relatively small thickness, and accordingly, the thickness of the flexible screen module 20 corresponding to the second screen body 21b and the volume of the part of the flexible screen module 20 can be reduced, thereby reducing the bending radius of the flexible screen module 20 corresponding to the second screen body 21b. By appropriately setting a width of the strip plates 253a and the interval between two adjacent strip plates 253a, the bending radius of the flexible screen module 20 corresponding to the second screen body 21b can be further reduced, so as to reduce the outer diameter of the guide member 30, allowing the structure of the electronic device 100 to be more compact and achieving the thin and light design of the electronic device 100. In some embodiments, the second plate 253 and the first plate 251 are both thin steel sheets. In other embodiments, the second plate 253 and the first plate 251 may be plastic sheets or the like.

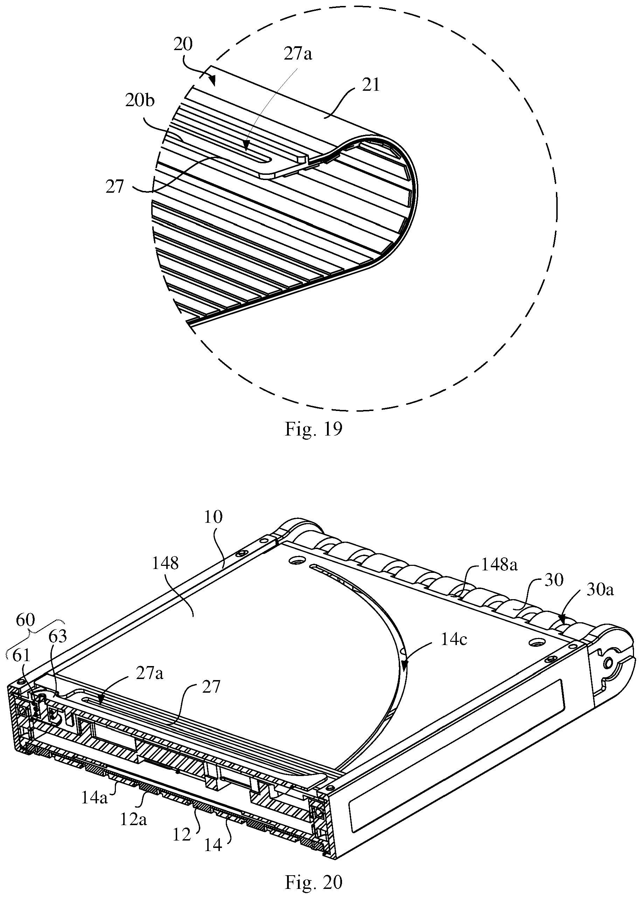

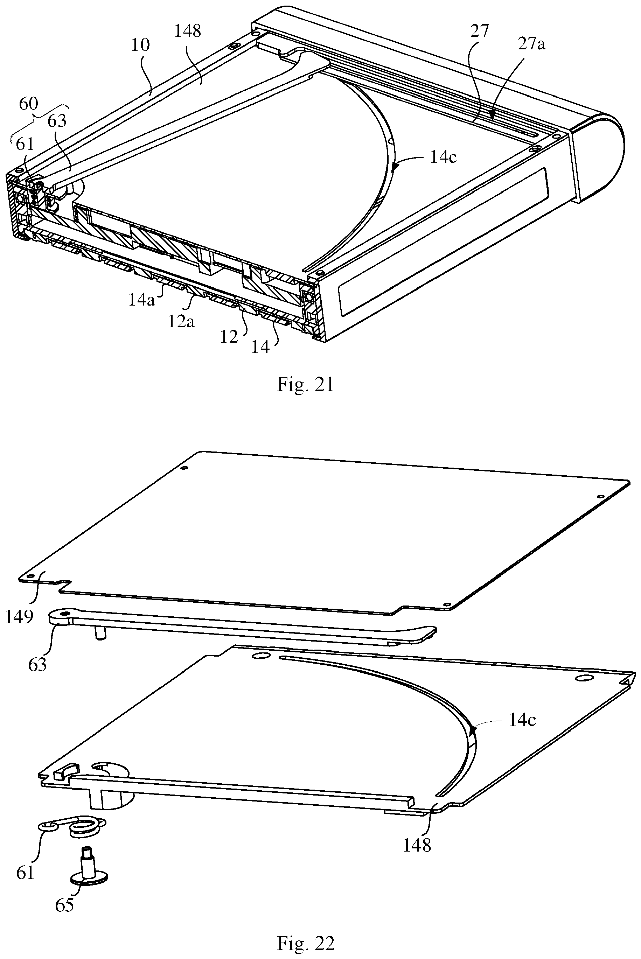

Referring to Fig. 19, the flexible screen module 20 may further include a sliding rail 27 connected to an end of the second screen body 21b facing away from the first screen body 21a, and the sliding rail 27 has a first slideway 27a. With reference to Fig. 20 and Fig. 21, in the embodiment of the present disclosure, in the process of the flexible screen module 20 entering and exiting the housing assembly 10, the tension assembly 60 can apply a tension force on the flexible screen module 20 through the slide rail 27 to unfold the part of the flexible screen module 20 exposed on the second support member 143, or to stably retract the part of the flexible screen module 20 unfolded on the second support member 143 into the housing assembly 10.

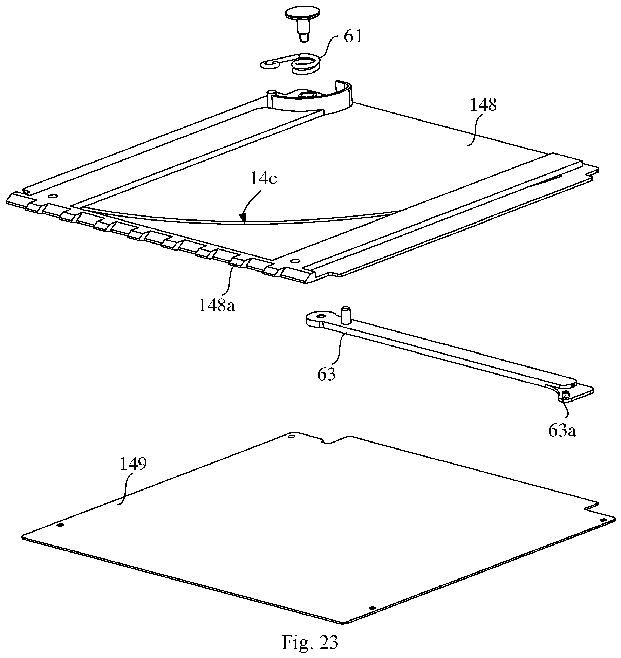

Referring to Fig. 20 and Fig. 21, in one embodiment, the tension assembly 60 is disposed in the housing assembly 10 and connected to the free end 20b of the flexible screen module 20. The tension assembly 60 includes an elastic member 61 and a movable member 63. The elastic member 61 and the movable member 63 are both connected to the second housing 14 and located in the housing assembly 10. A second slideway 14c is defined in the second housing 14, and an end of the movable member 63 is rotatably connected to the second housing 14. With reference to Fig. 22 and Fig. 23, the movable member 63 has a limit column 63a provided at the other end thereof, and the limit column 63a penetrates through the first slideway 27a and the second slideway 14c. In the process of switching the first housing 12 between the first position and the second position, the movable member 63 swings relative to the second housing 14 to apply the tension force on the flexible screen module 20.

Further, in the embodiment of the present disclosure, the elastic member 61 is a torsion spring, a free end of the torsion spring is connected to the second housing 14, and the other free end of the torsion spring is connected to the movable member 63. In the process of the first housing 12 switching between the first position and the second position, a torsional deformation of the torsion spring allows the movable member 63 to apply the tension force to the flexible screen module 20. Further, in the embodiment of the present disclosure, the movable member 63 is rotatably connected to the second housing 14 through a pin 65, and the torsion spring is sleeved on the pin 65 and generates the torsional deformation during the swing of the movable member 63.

In the process of the flexible screen module 20 stretching out of the housing assembly 10, i.e., in the process of switching the first housing 12 from the first position to the second position, the flexible screen module 20 drive the limit column 63a to swing through the slide rail 27, the torsion spring generates the torsional deformation and accumulates elastic potential energy, and the tension force, as resistance, is applied by the movable member 63 on the flexible screen module 20 through the slide rail 27, thereby enabling the flexible screen module 20 to be unfolded smoothly. In the process of the flexible screen module 20 retracting into the housing assembly 10, i.e., in the process of the first housing 12 switching from the second position to the first position, the torsion spring releases the elastic potential energy, and the tension force, as driving force, is applied by the movable member 63 on the flexible screen module 20 through the slide rail 27, thereby enabling the flexible screen module 20 to retract into the housing assembly 10 smoothly. That is, in the process of the flexible screen module 20 retracting into the housing assembly 10, the movable member 63 can be driven by the torsion spring to restore.

In some embodiments, a moving direction of the second housing 14 relative to the first housing 12 is perpendicular to the longitudinal extension direction of the first slideway 27a, and the second slideway 14c has an arc groove shape. The limit column 63a on the movable member 63 swings along the second slideway 14c having the arc groove shape, and the limit column 63a also slides in the first slideway 27a and pulls the slide rail 27, so as to tension the flexible screen module 20 through the interaction of the movable member 63 and the slide rail 27. In this embodiment, a swing angle of the movable member 63 is about 80 degrees. Referring to Fig. 20, as an example, a position of the movable member 63 when the first housing 12 is at the first position is regarded at an angle of zero point, the longitudinal extension direction of the first slideway 27a can be arranged in parallel to the movable member 63, that is, the longitudinal extension direction of the movable member 63 is arranged in parallel to the axial direction of the guide member 30. Referring to Fig. 21, compared to the first position, the movable member 63 swings about 80 degrees when the first housing is at the second position, and at this moment, the longitudinal extension direction of the movable member 63 is inclined with respect to the axial direction of the guide member 30. At this moment, the part of the flexible screen module 20 stretching out of the housing assembly 10 reaches the limit position, that is, the part of the second screen body 21b stretching out of the second housing 14 reaches the limit position.

Of course, in other embodiments, the swing angle of the movable member 63 may be greater than or equal to 90 degrees. At the second position, the longitudinal extension direction of the movable member 63 can be arranged perpendicular to the axial direction of the guide member 30, and at the first position, the movable member 63 can be arranged at an acute angle with respect to the axial direction of the guide member 30. In this embodiment, the retracting stroke of the second screen body 21b, i.e., the movement stroke of the slide rail 27, is greater than or equal to a distance between a center of the rotation shaft of the movable member 63 and a center of the limit column 63a.

In other embodiments, the tension assembly 60 may be connected to the first housing 12 and apply the tension force to the flexible screen module 20 in the process of the flexible screen module 20 entering and exiting from the channel. The tension assembly 60 may have other structural forms. For example, the movable member 63, the first slideway 27a, and the second slideway 14c can be omitted, and the tension assembly 60 includes an elastic rope connected to the second housing 14 or the first housing 12, and the elastic rope is configured to apply the tension force to the flexible screen module 20 along with the movement of the second housing 14 relative to the first housing 12.

Further referring to Fig. 22 and Fig. 23, the second housing 14 may include a bearing plate 148, and the bearing plate 148 and the second support member 143 are respectively located on opposite sides of the second bracket 141 (referring to Fig. 10). The bearing plate 148 can be detachably connected to the second bracket 141 by means of threaded fasteners, and the second slideway 14c is defined in the bearing plate 148. Of course, in other embodiments, the bearing plate 148 may be welded to the second bracket 141, or the bearing plate 148 may be formed into one piece with the second bracket 141. The bearing plate 148 has a second protrusion 148a provided at an end thereof close to the guide member 30. With reference to Fig. 20, the first protrusion 143a extends into the groove 30a. At least two second protrusions 148a can be provided and correspond to the grooves 30a on the guide member 30 in one-to-one correspondence. The structure of the second protrusion 148a can refer to the first protrusion 143a. For example, the second protrusion 148a can also have an arc surface a1 which will not be repeated here. The above structure can enable the flexible screen module 20 to move smoothly between the guide member 30 and the bearing plate 148, and prevent the flexible screen module 20 from bending and causing a jam at the gap between the bearing plate 148 and the guide member 30. Of course, the second protrusion 148a can also guide the flexible screen module 20 in the process of the flexible screen module 20 entering and exiting the housing assembly 10, allowing the flexible screen module 20 to be unfolded to be flat or smoothly retracted into the housing assembly 10. It can be understood that, by providing the second protrusion 148a, the requirement on the gap between the bearing plate 148 and the guide member 30 can be appropriately reduced, thereby reducing the requirement for assembly accuracy and improving assembly efficiency.

Further, referring to Fig. 22 and Fig. 23, the second housing 14 may include a cover plate 149 configured to cover a side of the bearing plate 148 facing away from the second supporting surface 14a, a second channel 14d is defined by the cover plate 149 and the bearing plate 148 (referring to Fig. 4), and the free end 20b of the flexible screen module 20 is movably received in the second channel 14d. In the process of the flexible screen module 20 entering and exiting the housing assembly 10, a rod-shaped body of the movable member 63 can swing in the second channel 14d. The cover plate 149 can shield and decorate the first screen body 21a of the flexible screen module 20, and can also limit the movement of the movable member 63 and the first screen body 21a within the second channel 14d.

It is understood that the cover plate 149 can be transparent or an opening, so as to form a light-transmitting area, and the first housing 12 can be located at one or several specific positions between the first position and the second position through the interaction between the positioning protrusion 145 and the slot 125, and the first screen body 21a exposed to the light-transmitting area is used for displaying. In this embodiment, the electronic device 100 may only be provided with a rear camera, and the first screen body 21a in the light-transmitting area can be used to exert functions such as selfie and video call, so as to save the cost of components of the electronic device 100 and save the internal housing assembly 10 of the electronic device 100.

Of course, the back cover 122 of the electronic device 100 may have a light-transmitting area. When the first housing 12 is at the first position, the light-transmitting area of the cover plate 149 corresponds to the light-transmitting area of the back cover 122, and thus the first screen body 21a exposed to the light-transmitting areas can be used for displaying. In this embodiment, the electronic device 100 may only be provided with a rear camera, and the first screen body 21a of the light-transmitting area and the other light-transmitting area is used to realize functions such as selfie and video call, so as to save the cost of the electronic device 100 and save the internal housing assembly 10 of the electronic device 100. In this embodiment, the first screen body 21a can be used for displaying when the first housing 12 is at the first position, thereby improving the convenience of use of the electronic device 100 and broadening the application scenarios of the electronic device 100.

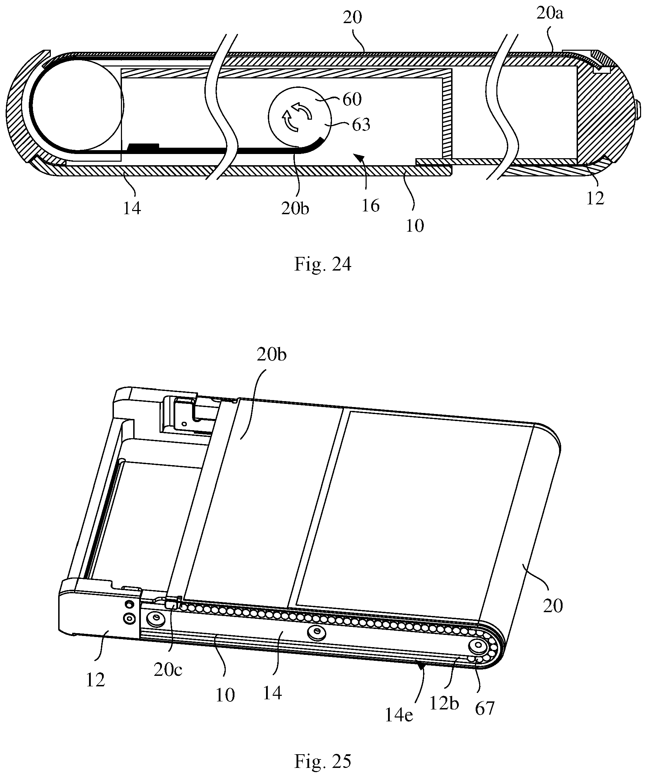

In other embodiments, the tension assembly 60 may have other structural forms. Referring to Fig. 24, in another embodiment, the movable member 63 is rotatably connected to the second housing 14. In the process of the flexible screen module 20 stretching out of the housing assembly 10, the movable member 63 is driven by the flexible screen module 20 to rotate relative to the second housing 14 to release the flexible screen module 20 wound around the movable member 63, and the elastic member 61 (not shown) accumulates elastic potential energy. In the process of the flexible screen module 20 retracting into the housing assembly 10, the elastic member 61 releases the elastic potential energy and the movable member 63 is driven to restore, so that the free end 20b is wound around the movable member 63. In this embodiment, the elastic member 61 may be a torsion spring sleeved on the movable member 63.

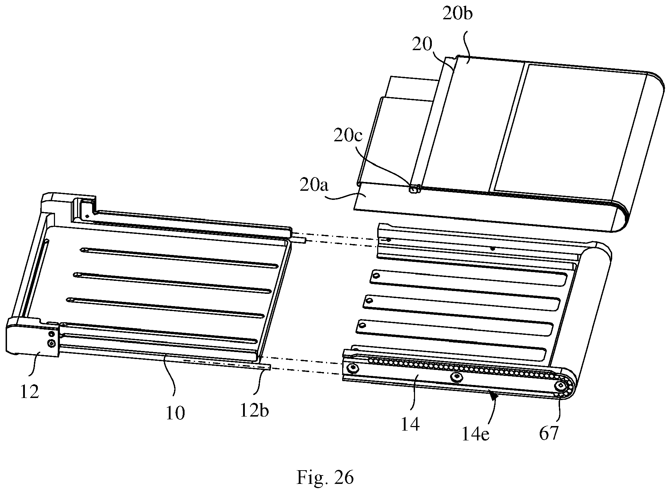

Referring to Fig. 25 and Fig. 26, in another embodiment, the tension assembly 60 may include a plurality of transmission bodies 67, a guide recess 14e is defined in the second housing 14, the plurality of transmission bodies 67 are arranged sequentially along an extension direction of the guide recess 14e, the free end 20b of the flexible screen module 20 is provided at one end of the tension assembly 60, and the first housing 12 is disposed at the other end of the tension assembly 60. In the process of the flexible screen module 20 stretching out of the housing assembly 10, the plurality of transmission bodies 67 is pushed by the free end 20b to abut against each other sequentially and moves along the guide recess 14e. In the process of the flexible screen module 20 retracting into the housing assembly 10, the plurality of transmission bodies 67 is pushed by the first housing 12 to abut against each other sequentially and moves along the guide recess 14e. Specifically, in the embodiment illustrated in Fig. 26, the guide recess 14e is defined on each of the two sides of the moving direction of the first housing 12 relative to the second housing 14, and each guide recess 14e is correspondingly provided with the tension assembly 60. Further, the transmission body 67 is a cylinder or a ball, and the transmission body 67 is slidable or rollable in the guide recess 14e.

The guide recess 14e is substantially in a U-shape, and the first housing 12 has a first pushing portion 12b provided at one end thereof. The first pushing portion 12b is a part of the first housing 12 disposed in and penetrating through the guide recess 14e. The flexible screen module 20 has a second pushing portion 20c provided at the free end 20b thereof. The second pushing portion 20c is a part of the flexible screen module 20 disposed in and penetrating through the guide recess 14e. In the process of the flexible screen module 20 stretching out of the housing assembly 10, the opposite ends of the first housing 12 and the second housing 14 depart from each other, the second pushing portion 20c of the free end 20b pushes the transmission bodies 67 at one end of the tension assembly 60 to abut against each other in sequence and move along the guide recess 14e, while the transmission bodies 67 located at the other end of the tension assembly 60 generate a pushing force on the first pushing portion 12b. In other words, in the process of the flexible screen module 20 stretching out of the housing assembly 10, the two ends of the tension assembly 60 generate the pushing forces on the first pushing portion 12b and the second pushing portion 20c, respectively, and the free end 20b and the fixed end 20a of the flexible screen module 20 tend to depart from each other. That is, the tension assembly 60 generates tension force exerting on the flexible screen module 20, so as to keep the flexible screen module 20 in an unfolded and flat state. Similarly, in the process of the flexible screen module 20 retracting into the housing assembly 10, the opposite ends of the first housing 12 and the second housing 14 approach to each other, and the first pushing portion 12b of the first housing 12 pushes the transmission body 67 at one end of the tension assembly 60 to enable the plurality of transmission bodies 67 to abut against each other in sequence and move along the guide recess 14e, while the transmission bodies 67 located at the other end of the tension assembly 60 generate a pushing force on the second pushing portion 20c. In other words, in the process of the flexible screen module 20 retracting into the housing assembly 10, the two ends of the tension assembly 60 generate the pushing forces on the first pushing portion 12b and the second pushing portion 20c, respectively, and the free end 20b and the fixed end 20a of the flexible screen module 20 tend to depart from each other. That is, the tension assembly 60 generates the tension force exerting on the flexible screen module 20 to keep the flexible screen module 20 in the unfolded and flat state.

Of course, the tension assembly 60 may be implemented in other forms. For example, in an implementation where the electronic device 100 includes a driving mechanism, the driving mechanism may be connected to the free end of the flexible screen module 20. In the process of the flexible screen module 20 stretching out of the housing assembly 10, the driving mechanism gradually releases the flexible screen module 20 and applies a tension force to the flexible screen module 20, so that the flexible screen module 20 can be flatly unfolded on the second housing 14. In the process of the flexible screen module 20 retracting into the housing assembly 10, the driving mechanism drives the free end of the flexible screen module 20 to gradually wind on the shaft, so as to steadily retract the flexible screen module 20 into the housing assembly 10. In such an implementation, the driving mechanism may be a motor, or a combination of a motor and a gear set.

The above-mentioned embodiments are merely several embodiments of the present disclosure, and the description thereof is relatively specific and detailed. However, the above-mentioned embodiments should not be understood as limitations on the scope of the present disclosure. The protection scope of the present disclosure should be determined by the appended claims.

## Claims

1. An electronic device (100), comprising:
a housing assembly (10) comprising a first housing (12), and a second housing (14) connected to the first housing (12), wherein the first housing (12) has a first supporting surface (12a), the second housing (14) has a second supporting surface (14a), and the first supporting surface (12a) is flush with the second supporting surface (14a);
a tension assembly (60) connected to the housing assembly (10); and
a flexible screen module (20) comprising a fixed end (20a), and a free end (20b) opposite to the fixed end (20a), wherein the fixed end (20a) is connected to the first housing (12) and supported by the first supporting surface (12a), the free end (20b) bypasses an end of the second housing (14) facing away from the first housing (12) and extends into the housing assembly (10), and the free end (20b) is connected to the tension assembly (60),
wherein the first housing (12) is movable relative to the second housing (14) to enable at least a part of the flexible screen module (20) to unfold on the second supporting surface (14a) or to retract into the housing assembly (10),
wherein the tension assembly (60) comprises an elastic member (61) and a movable member (63); the second housing (14), the free end (20b), and the elastic member (61) are connected to the movable member (63), and the elastic member (61) is connected to the second housing (14), **characterized in that**,
the free end (20b) has a first slideway (27a) defined therein; one end of the movable member (63) is rotatably connected to the second housing (14), the movable member (63) has a limit column (63a) provided on the other end thereof and disposed in and penetrating through the first slideway (27a); in the process of the flexible screen module (20) unfolding from the housing assembly (10), the movable member (63) is driven by the flexible screen module (20) to swing relative to the second housing (14) and enable the limit column (63a) to slide along the first slideway (27a); and in the process of the flexible screen module (20) retracting into the housing assembly (10), the movable member (63) is driven by the elastic member (61) to swing and to restore.

2. The electronic device (100) according to claim 1, wherein the elastic member (61) is a torsion spring sleeved on the movable member (63).

3. The electronic device (100) according to claim 1, wherein the second housing (14) has a second slideway (14c) defined therein and having an arc shape, and the limit column (63a) is disposed in and penetrates through the second slideway (14c) and slidable along the second slideway (14c);
the first housing (12) comprises a first bracket (121), and a first support member (123) connected to the first bracket (121) and having the first supporting surface (12a); and
the second housing (14) comprises a second bracket (141), and a second support member (143) connected to the second bracket (141) and having the second supporting surface (14a).

4. The electronic device (100) according to claim 3, wherein a plurality of limit grooves (123a) spaced apart from each other is defined on the first supporting surface (12a) of the first support member (123); the second support member (143) comprises a connection portion (143b) , and a plurality of limit portions (143c) extending from the connection portion (143b) and having at least a part of the second supporting surface (14a); the plurality of limit portions (143c) is disposed at an end of the connection portion (143b) close to the fixed end (20a) and corresponds to the plurality of limit grooves (123a) in one-to-one correspondence; and in a process of the first housing (12) moving relative to the second housing (14), each of the plurality of limit portions (143c) is movable in one corresponding limit groove (123a) of the plurality of limit grooves.

5. The electronic device (100) according to claim 4, wherein each of the plurality of limit portions (143c) has a guide protrusion bar (143d) provided at an edge thereof and extending in a moving direction of the first housing (12), the guide protrusion bar (143d) has an end surface on a same side as the second supporting surface (14a), and a height difference exists between the end surface and the second supporting surface (14a); and each of the plurality of limit grooves (123a) is a sinking groove and extends along a moving direction of the second housing (14), the sinking groove has a lug (123b) provided at a side wall thereof and spaced apart from a bottom of the sinking groove, a guide groove (123c) is defined between the lug (123b) and the bottom of the sinking groove, and the guide protrusion bar (143d) is disposed in and penetrates through the guide groove (123c).

6. The electronic device (100) according to claim 3, wherein sliding grooves (121a) are defined on both sides of the first bracket (121), and the second bracket (141) is slidably disposed in the sliding grooves (121a).

7. The electronic device (100) according to claim 3, wherein one of the first bracket (121) and the second bracket (141) has a positioning protrusion (145) provided thereon, and the other one of the first bracket (121) and the second bracket (141) has a slot (125) defined therein; and in a process of the first housing (12) moving relative to the second housing (14), the positioning protrusion (145) is able to enter the slot (125) to fix the first housing (12) in the second housing (14).

8. The electronic device (100) according to claim 3, further comprising a guide member (30) rotatably disposed on the second bracket (141), wherein the free end (20b) bypasses the guide member (30) and extends into the housing assembly (10); and
wherein the second housing (14) comprises a rotation shaft (147) connected to the second bracket (141), and the guide member (30) is sleeved on the rotation shaft (147) and rotatably fits the rotation shaft (147).

9. The electronic device (100) according to claim 8, wherein a plurality of grooves (30a) surrounding the guide member (30) is defined in the guide member (30), and the plurality of grooves is spaced apart from each other along an axial direction of the guide member (30); the second support member (143) comprises a plurality of first lugs provided at an end of close to the guide member (30), the plurality of first lugs corresponds to the plurality of grooves (30a) in one-to-one correspondence, and each of the plurality of first lugs extends into one corresponding groove (30a) of the plurality of grooves (30a).

10. The electronic device (100) according to claim 9, wherein the second housing (14) comprises a bearing plate (148) connected to the second bracket (141), the bearing plate (148) and the second support member (143) are located on two opposite sides of the second bracket (141), respectively, and the free end (20b) is movable on a side of the bearing plate (148) facing away from the second bracket (141); and the second slideway (14c) is located in the bearing plate (148), the movable member (63) and the elastic member (61) are both connected to the bearing plate (148), and the bearing plate (148) has a second protrusion (148a) provided at an end thereof close to the guide member (30), the second protrusion (148a) protruding into the groove.

11. The electronic device (100) according to claim 10, wherein the second housing (14) further comprises a cover plate configured to cover a side of the bearing plate (148) facing away from the second bracket (141), and a channel is defined by the cover plate and the bearing plate (148); the free end (20b) is movably received in the channel, and in processes of the flexible screen module (20) unfolding and retracting, a partial structure of the movable member (63) swings in the channel.

12. The electronic device (100) according to claim 1, wherein the movable member (63) is rotatably connected to the second housing (14), and in the process of the flexible screen module (20) unfolding from the housing assembly (10), the movable member (63) is driven by the flexible screen module (20) to rotate relative to the second housing (14) to release the flexible screen module (20) wound around the movable member (63); and in the process of the flexible screen module (20) retracting into the housing assembly (10), the movable member (63) is driven by the elastic member (61) to restore to wind the free end (20b) on the movable member (63).

13. The electronic device (100) according to claim 1, wherein a guide recess (14e) is defined in the second housing (14) on each of two sides of a moving direction of the first housing (12) relative to the second housing (14), the guide recess (14e) is correspondingly provided with the tension assembly (60), the tension assembly (60) comprises a plurality of transmission bodies (67) arranged sequentially along an extension direction of the guide recess (14e), the free end (20b) is disposed at one end of the tension assembly (60), and the first housing (12) is disposed at the other end of the tension assembly (60); in the process of the flexible screen module (20) unfolding from the housing assembly (10), the plurality of transmission bodies (67) is pushed by the free end (20b) to abut against each other sequentially and move along the guide recess (14e), enabling the plurality of transmission bodies (67) to press against the first housing (12); and in the process of the flexible screen module (20) retracting into the housing assembly (10), the plurality of transmission bodies (67) is pushed by the first housing (12) to abut against each other sequentially and move along the guide recess (14e), enabling the plurality of transmission bodies (67) to press against the free end (20b), preferably, each of the plurality of transmission bodies (67) is a cylinder or a sphere.

14. The electronic device (100) according to any one of claims 1 to 13, wherein the flexible screen module (20) comprises:
a flexible display (21);
a reinforcement layer (23) stacked on the flexible display (21); and
a support plate (25) stacked on the reinforcement layer (23) and located on a side of the reinforcement layer (23) facing away from the flexible display (21),
wherein the support plate (25) comprises a first plate (251) connected to the fixed end (20a) and supported by the first supporting surface (12a), and a second plate (253) connected to the free end (20b) and the tension assembly (60) and bypassing the end of the second housing (14) facing away from the first housing (12); and wherein the second plate (253) comprises a plurality of strip plates (253a) spaced apart from each other, and a longitudinal extension direction of the plurality of strip plates (253a) is perpendicular to a moving direction of the first housing (12) relative to the second housing (14).

## Patentansprüche

1. Elektronische Vorrichtung (100), umfassend:
eine Gehäuseanordnung (10), umfassend ein erstes Gehäuse (12) und ein zweites Gehäuse (14), das mit dem ersten Gehäuse (12) verbunden ist, wobei das erste Gehäuse (12) eine erste Stützoberfläche (12a) aufweist, das zweite Gehäuse (14) eine zweite Stützoberfläche (14a) aufweist, und die erste Stützoberfläche (12a) bündig mit der zweiten Stützoberfläche (14a) ist;
eine Spannanordnung (60), die mit der Gehäuseanordnung (10) verbunden ist; und
ein flexibles Bildschirmmodul (20), umfassend ein Fixende (20a) und ein freies Ende (20b) gegenüber von dem Fixende (20a), wobei das Fixende (20a) mit dem ersten Gehäuse (12) verbunden ist und von der ersten Stützoberfläche (12a) gestützt wird, das freie Ende (20b) ein Ende des zweiten Gehäuses (14) umgeht, das von dem ersten Gehäuse (12) weg weist, und sich in die Gehäuseanordnung (10) erstreckt, und das freie Ende (20b) mit der Spannanordnung (60) verbunden ist,
wobei das erste Gehäuse (12) relativ zu dem zweiten Gehäuse (14) beweglich ist, um zu ermöglichen, dass sich mindestens ein Teil des flexiblen Bildschirmmoduls (20) auf der zweiten Stützoberfläche (14a) entfaltet oder in die Gehäuseanordnung (10) zurückzieht,
wobei die Spannanordnung (60) ein elastisches Element (61) und ein bewegliches Element (63) umfasst; das zweite Gehäuse (14), das freie Ende (20b) und das elastische Element (61) mit dem beweglichen Element (63) verbunden sind, und das elastische Element (61) mit dem zweiten Gehäuse (14) verbunden ist, **dadurch gekennzeichnet, dass**
das freie Ende (20b) eine darin definierte erste Gleitbahn (27a) aufweist; ein Ende des beweglichen Elements (63) drehbar mit dem zweiten Gehäuse (14) verbunden ist, das bewegliche Element (63) eine Grenzsäule (63a) aufweist, die auf seinem anderen Ende bereitgestellt ist und in der ersten Gleitbahn (27a) angeordnet ist und diese durchdringt; wobei das bewegliche Element (63) in dem Prozess des Entfaltens des flexiblen Bildschirmmoduls (20) aus der Gehäuseanordnung (10) von dem flexiblen Bildschirmmodul (20) angetrieben wird, um relativ zu dem zweiten Gehäuse (14) zu schwenken und zu ermöglichen, dass die Grenzsäule (63a) an der ersten Gleitbahn (27a) entlang gleitet; und das bewegliche Element (63) in dem Prozess des Zurückziehens des flexiblen Bildschirmmoduls (20) in die Gehäuseanordnung (10) durch das elastische Element (61) angetrieben wird, um zu schwenken und sich zurückzustellen.

2. Elektronische Vorrichtung (100) nach Anspruch 1, wobei das elastische Element (61) eine Torsionsfeder ist, die manschettenartig auf dem beweglichen Element (63) liegt.

3. Elektronische Vorrichtung (100) nach Anspruch 1, wobei das zweite Gehäuse (14) eine darin definierte zweite Gleitbahn (14c) aufweist und eine Bogenform aufweist, und die Grenzsäule (63a) in der zweiten Gleitbahn (14c) angeordnet ist und diese durchdringt und entlang der zweiten Gleitbahn (14c) gleitfähig ist; das erste Gehäuse (12) einen ersten Halter (121) und ein erstes Stützelement (123) umfasst, das mit dem ersten Halter (121) verbunden ist und die erste Stützoberfläche (12a) aufweist; und
das zweite Gehäuse (14) einen zweite Halter (141) und ein zweites Stützelement (143) umfasst, mit dem zweiten Halter (141) verbunden ist und die zweite Stützoberfläche (14a) aufweist.

4. Elektronische Vorrichtung (100) nach Anspruch 3, wobei eine Vielzahl von Grenzrillen (123a), die voneinander beabstandet sind, auf der ersten Stützoberfläche (12a) des ersten Stützelements (123) definiert ist; das zweite Stützelement (143) einen Verbindungsabschnitt (143b) umfasst, und eine Vielzahl von Grenzabschnitten (143c) sich von dem Verbindungsabschnitt (143b) erstreckt und mindestens einen Teil der zweiten Stützoberfläche (14a) aufweist; die Vielzahl der Grenzabschnitte (143c) an einem Ende des Verbindungsabschnitts (143b) nahe dem Fixende (20a) angeordnet ist und in einer eins-zu-eins-Entsprechung der Vielzahl der Grenzrillen (123a) entspricht; und in einem Prozess, in dem sich das erste Gehäuse (12) relativ zu dem zweiten Gehäuse (14) bewegt, jeder von der Vielzahl der Grenzabschnitte (143c) in einer entsprechenden Grenzrille (123a) von der Vielzahl der Grenzrillen beweglich ist.

5. Elektronische Vorrichtung (100) nach Anspruch 4, wobei jeder von der Vielzahl der Grenzabschnitte (143c) eine Führungsvorsprungleiste (143d) aufweist, die an einem Rand davon bereitgestellt wird und sich in eine Bewegungsrichtung des ersten Gehäuses (12) erstreckt, wobei die Führungsvorsprungleiste (143d) eine Endoberfläche auf der gleichen Seite wie die zweite Stützoberfläche (14a) aufweist und eine Höhendifferenz zwischen der Endoberfläche und der zweiten Stützoberfläche (14a) vorhanden ist; und jede von der Vielzahl der Grenzrillen (123a) eine Senkrille ist und sich entlang einer Bewegungsrichtung des zweiten Gehäuses (14) erstreckt, wobei die Senkrille einen Ansatz (123b) aufweist, der an einer Seitenwand davon bereitgestellt wird und von einem Boden der Senkrille beanstandet ist, eine Führungsrille (123c) zwischen dem Ansatz (123b) und dem Boden der Senkrille definiert ist, und die Führungsvorsprungleiste (143d) in der Führungsrille (123c) angeordnet ist und durch diese hindurch dringt.

6. Elektronische Vorrichtung (100) nach Anspruch 3, wobei auf beiden Seiten des ersten Halters (121) Gleitrillen (121a) definiert sind und der zweite Halter (141) gleitfähig in den Gleitrillen (121a) angeordnet ist.

7. Elektronische Vorrichtung (100) nach Anspruch 3, wobei einer von dem ersten Halter (121) und dem zweiten Halter (141) einen darauf bereitgestellten Positionierungsvorsprung (145) aufweist, und der andere von dem ersten Halter (121) und dem zweiten Halter (141) einen darin definierten Schlitz (125) aufweist; und in einem Prozess, in dem sich das erste Gehäuse (12) relativ zu dem zweiten Gehäuse (14) bewegt, der Positionierungsvorsprung (145) in der Lage ist, in den Schlitz (125) einzutreten, um das erste Gehäuse (12) in dem zweiten Gehäuse (14) zu fixieren.

8. Elektronische Vorrichtung (100) nach Anspruch 3, des Weiteren umfassend ein Führungselement (30), das drehbar auf dem zweiten Halter (141) angeordnet ist, wobei das freie Ende (20b) das Führungselement (30) umgeht und sich in die Gehäuseanordnung (10) erstreckt; und
wobei das zweite Gehäuse (14) eine Drehwelle (147) umfasst, die mit dem zweiten Halter (141) verbunden ist, und das Führungselement (30) manschettenartig auf der Drehwelle (147) liegt und drehbar auf die Drehwelle (147) passt.

9. Elektronische Vorrichtung (100) nach Anspruch 8, wobei eine Vielzahl von Rillen (30a), welche das Führungselement (30) umgeben, in dem Führungselement (30) definiert ist und die Vielzahl der Rillen entlang einer axialen Richtung des Führungselements (30) voneinander beabstandet ist; das zweite Stützelement (143) eine Vielzahl erster Ansätze umfasst, die an einem Ende nahe an dem Führungselement (30) bereitgestellt ist, wobei die Vielzahl der ersten Ansätze der Vielzahl von Rillen (30a) in einer eins-zu-eins-Entsprechung entspricht und jede von der Vielzahl der ersten Ansätze sich in eine entsprechende Rille (30a) von der Vielzahl der Rillen (30a) erstreckt.

10. Elektronische Vorrichtung (100) nach Anspruch 9, wobei das zweite Gehäuse (14) eine Lagerplatte (148) umfasst, die mit dem zweiten Halter (141) verbunden ist, wobei die Lagerplatte (148) und das zweite Stützelement (143) sich auf zwei gegenüber liegenden Seiten des zweiten Halters (141) befinden und das freie Ende (20b) auf einer Seite der Lagerplatte (148) beweglich ist, die von dem zweiten Halter (141) weg weist; und die zweite Gleitbahn (14c) sich in der Lagerplatte (148) befindet, das bewegliche Element (63) und das elastische Element (61) beide mit der Lagerplatte (148) verbunden sind, und die Lagerplatte (148) einen zweiten Vorsprung (148a) aufweist, der auf seinem Ende nahe an dem Führungselement (30) bereitgestellt wird, wobei der zweite Vorsprung (148a) in die Rille vorspringt.

11. Elektronische Vorrichtung (100) nach Anspruch 10, wobei das zweite Gehäuse (14) des Weiteren eine Abdeckplatte umfasst, die ausgestaltet ist, um eine Seite der Lagerplatte (148) zu bedecken, die von dem zweiten Halter (141) weg weist, und durch die Abdeckplatte und die Lagerplatte (148) ein Kanal definiert ist; wobei das freie Ende (20b) beweglich in dem Kanal aufgenommen wird und in den Prozessen des Entfaltens und Zurückziehens des flexiblen Bildschirmmoduls (20) eine Teilstruktur des beweglichen Elements (63) in dem Kanal schwenkt.

12. Elektronische Vorrichtung (100) nach Anspruch 1, wobei das bewegliche Element (63) drehbar mit dem zweiten Gehäuse (14) verbunden ist und das bewegliche Element (63) in dem Prozess des Entfaltens des flexiblen Bildschirmmoduls (20) aus der Gehäuseanordnung (10) durch das flexible Bildschirmmodul (20) angetrieben wird, um sich relativ zu dem zweiten Gehäuse (14) zu drehen, um das um das bewegliche Element (63) gewickelte flexible Bildschirmmodul (20) freizugeben; und wobei das bewegliche Element (63) in dem Prozess des Zurückziehens des flexiblen Bildschirmmoduls (20) in die Gehäuseanordnung (10) durch das elastische Element (61) zur Rückstellung angetrieben wird, um das freie Ende (20b) auf das bewegliche Element (63) zu wickeln.

13. Elektronische Vorrichtung (100) nach Anspruch 1, wobei eine Führungsvertiefung (14e) in dem zweiten Gehäuse (14) auf jeder von zwei Seiten einer Bewegungsrichtung des ersten Gehäuses (12) relativ zu dem zweiten Gehäuse (14) definiert ist, wobei die Führungsvertiefung (14e) entsprechend mit der Spannanordnung (60) bereitgestellt wird, die Spannanordnung (60) eine Vielzahl von Übertragungskörpern (67) umfasst, die sequentiell entlang einer Ausdehnungsrichtung der Führungsvertiefung (14e) angeordnet sind, das freie Ende (20b) an einem Ende der Spannanordnung (60) angeordnet ist, und das erste Gehäuse (12) an dem anderen Ende der Spannanordnung (60) angeordnet ist; die Vielzahl der Übertragungskörper (67) in dem Prozess des Entfaltens des flexiblen Bildschirmmoduls (20) aus der Gehäuseanordnung (10) durch das freie Ende (20b) so geschoben werden, dass sie sequentiell aneinander anliegen und sich entlang der Führungsaussparung (14e) bewegen, wodurch ermöglicht wird, dass die Vielzahl der Übertragungskörper (67) gegen das erste Gehäuse (12) presst; und wobei die Vielzahl der Übertragungskörper (67) in dem Prozess des Zurückziehens des flexiblen Bildschirmmoduls (20) in die Gehäuseanordnung (10) durch das erste Gehäuse (12) geschoben wird, so dass sie sequentiell aneinander anliegen und sich an der Führungsvertiefung (14e) entlang bewegen, wodurch ermöglicht wird, dass die Vielzahl der Übertragungskörper (67) gegen das freie Ende (20b) presst, wobei vorzugsweise jeder von der Vielzahl der Übertragungskörper (67) ein Zylinder oder eine Kugel ist.

14. Elektronische Vorrichtung (100) nach einem der Ansprüche 1 bis 13, wobei das flexible Bildschirmmodul (20) umfasst:
eine flexible Anzeige (21);
eine Verstärkungsschicht (23), die auf die flexible Anzeige (21) gestapelt ist; und
eine Stützplatte (25), die auf die Verstärkungsschicht (23) gestapelt ist und sich auf einer Seite der Verstärkungsschicht (23) befindet, die von der flexiblen Anzeige (21) weg weist,
wobei die Stützplatte (25) eine erste Platte (251), die mit dem Fixende (20a) verbunden und durch die erste Stützoberfläche (12a) gestützt wird, und eine zweite Platte (253) umfasst, die mit dem freien Ende (20b) und der Spannanordnung (60) verbunden ist und das Ende des zweiten Gehäuses (14) umgeht, das von dem ersten Gehäuse (12) weg weist; und wobei die zweite Platte (253) eine Vielzahl von Streifenplatten (253a) umfasst, die voneinander beabstandet sind, und eine Längsausdehnungsrichtung der Vielzahl von Streifenplatten (253a) senkrecht zu einer Bewegungsrichtung des ersten Gehäuses (12) relativ zu dem zweiten Gehäuse (14) ist.

## Revendications

1. Dispositif électronique (100), comprenant :
un ensemble de boîtier (10) comprenant un premier boîtier (12), et un second boîtier (14) relié au premier boîtier (12), le premier boîtier (12) ayant une première surface de support (12a), le second boîtier (14) ayant une seconde surface de support (14a), et la première surface de support (12a) étant au même niveau que la seconde surface de support (14a) ;
un ensemble de mise en tension (60) relié à l'ensemble de boîtier (10) ; et
un module d'écran flexible (20) comprenant une extrémité fixe (20a), et une extrémité libre (20b) opposée à l'extrémité fixe (20a), l'extrémité fixe (20a) étant reliée au premier boîtier (12) et supportée par la première surface de support (12a), l'extrémité libre (20b) contournant une extrémité du second boîtier (14) orientée à l'opposé du premier boîtier (12) et s'étendant dans l'ensemble de boîtier (10), et l'extrémité libre (20b) étant reliée à l'ensemble de mise en tension (60),
le premier boîtier (12) étant mobile par rapport au second boîtier (14) pour permettre à au moins une partie du module d'écran flexible (20) de se déplier sur la seconde surface de support (14a) ou de se rétracter dans l'ensemble de boîtier (10),
l'ensemble de mise en tension (60) comprenant un élément élastique (61) et un élément mobile (63) ; le second boîtier (14), l'extrémité libre (20b) et l'élément élastique (61) étant reliés à l'élément mobile (63), et l'élément élastique (61) étant relié au second boîtier (14), **caractérisé en ce que** l'extrémité libre (20b) a une première glissière (27a) définie à l'intérieur ; une extrémité de l'élément mobile (63) étant reliée de manière rotative au second boîtier (14), l'élément mobile (63) ayant une colonne de limite (63a) prévue sur son autre extrémité et disposée dans la première glissière (27a) et pénétrant à travers celle-ci ; dans le processus de dépliement du module d'écran flexible (20) à partir de l'ensemble de boîtier (10), l'élément mobile (63) étant entraîné par le module d'écran flexible (20) pour osciller par rapport au second boîtier (14) et permettre à la colonne de limite (63a) de glisser le long de la première glissière (27a) ; et dans le processus de rétraction du module d'écran flexible (20) dans l'ensemble de boîtier (10), l'élément mobile (63) étant entraîné par l'élément élastique (61) pour osciller, et se rétablir.

2. Dispositif électronique (100) selon la revendication 1, l'élément élastique (61) étant un ressort de torsion manchonné sur l'élément mobile (63).

3. Dispositif électronique (100) selon la revendication 1, le second boîtier (14) ayant une seconde glissière (14c) définie à l'intérieur et ayant une forme d'arc, et la colonne de limite (63a) étant disposée dans la seconde glissière (14c) et y pénétrant, et pouvant coulisser le long de la seconde glissière (14c) ;
le premier boîtier (12) comprenant une première plaque de fixation (121), et un premier élément de support (123) relié à la première plaque de fixation (121) et ayant la première surface de support (12a) ; et
le second boîtier (14) comprenant une seconde plaque de fixation (141), et un second élément de support (143) relié à la seconde plaque de fixation (141) et ayant la seconde surface de support (14a).

4. Dispositif électronique (100) selon la revendication 3, une pluralité de rainures de limite (123a) espacées les unes des autres étant définie sur la première surface de support (12a) du premier élément de support (123) ; le second élément de support (143) comprenant une partie de connexion (143b), et une pluralité de parties de limite (143c) s'étendant à partir de la partie de connexion (143b) et ayant au moins une partie de la seconde surface de support (14a) ; la pluralité de parties de limite (143c) étant disposée à une extrémité de la partie de connexion (143b) proche de l'extrémité fixe (20a) et correspondant à la pluralité de rainures de limite (123a) en correspondance biunivoque ; et dans un processus de déplacement du premier boîtier (12) par rapport au second boîtier (14), chacune de la pluralité de parties de limite (143c) étant mobile dans une rainure de limite correspondante (123a) de la pluralité de rainures de limite.

5. Dispositif électronique (100) selon la revendication 4, chacune de la pluralité de parties de limite (143c) ayant une barre de saillie de guidage (143d) prévue sur un de ses bords et s'étendant dans une direction de déplacement du premier boîtier (12), la barre de saillie de guidage (143d) ayant une surface d'extrémité sur un même côté que la seconde surface de support (14a), et une différence de hauteur existant entre la surface d'extrémité et la seconde surface de support (14a) ; et chacune de la pluralité de rainures de limite (123a) étant une rainure d'enfoncement et s'étendant le long d'une direction de déplacement du second boîtier (14), la rainure d'enfoncement ayant un ergot (123b) prévu sur une de ses parois latérales et espacé d'un fond de la rainure d'enfoncement, une rainure de guidage (123c) étant définie entre l'ergot (123b) et le fond de la rainure d'enfoncement, et la barre de saillie de guidage (143d) étant disposée dans la rainure de guidage (123c) et pénétrant à travers cette dernière.

6. Dispositif électronique (100) selon la revendication 3, des rainures de coulissement (121a) étant définies des deux côtés de la première plaque de fixation (121), et la seconde plaque de fixation (141) étant disposée de manière coulissante dans les rainures de coulissement (121a).

7. Dispositif électronique (100) selon la revendication 3, l'une de la première plaque de fixation (121) et de la seconde plaque de fixation (141) ayant une saillie de positionnement (145) prévue sur celle-ci, et l'autre de la première plaque de fixation (121) et de la seconde plaque de fixation (141) ayant une fente (125) définie dans celle-ci ; et dans un processus de déplacement du premier boîtier (12) par rapport au second boîtier (14), la saillie de positionnement (145) étant capable d'entrer dans la fente (125) pour fixer le premier boîtier (12) dans le second boîtier (14).

8. Dispositif électronique (100) selon la revendication 3, comprenant en outre un élément de guidage (30) disposé de manière rotative sur la seconde plaque de fixation (141), l'extrémité libre (20b) contournant l'élément de guidage (30) et s'étendant à l'intérieur de l'ensemble de boîtier (10), et
le second boîtier (14) comprenant un arbre de rotation (147) relié à la seconde plaque de fixation (141), et l'élément de guidage (30) étant manchonné sur l'arbre de rotation (147) et s'adaptant de manière rotative à l'arbre de rotation (147).

9. Dispositif électronique (100) selon la revendication 8, une pluralité de rainures (30a) entourant l'élément de guidage (30) étant définie dans l'élément de guidage (30), et la pluralité de rainures étant espacées les unes des autres le long d'une direction axiale de l'élément de guidage (30) ; le second élément de support (143) comprenant une pluralité de premiers ergots prévus à une extrémité près de l'élément de guidage (30), la pluralité de premiers ergots correspondant à la pluralité de rainures (30a) en correspondance biunivoque, et chacun de la pluralité de premiers ergots s'étendant dans une rainure correspondante (30a) de la pluralité de rainures (30a).

10. Dispositif électronique (100) selon la revendication 9, le second boîtier (14) comprenant une plaque d'appui (148) reliée à la seconde plaque de fixation (141), la plaque d'appui (148) et le second élément de support (143) étant situés sur deux côtés opposés de la seconde plaque de fixation (141), respectivement, et l'extrémité libre (20b) étant mobile sur un côté de la plaque d'appui (148) orienté à l'opposé de la seconde plaque de fixation (141) ; et la seconde glissière (14c) étant située dans la plaque d'appui (148), l'élément mobile (63) et l'élément élastique (61) étant tous deux reliés à la plaque d'appui (148), et la plaque d'appui (148) ayant une seconde saillie (148a) prévue à une de ses extrémités à proximité de l'élément de guidage (30), la seconde saillie (148a) faisant saillie dans la rainure.

11. Dispositif électronique (100) selon la revendication 10, le second boîtier (14) comprenant en outre une plaque de recouvrement configurée pour recouvrir un côté de la plaque d'appui (148) orienté à l'opposé de la seconde plaque de fixation (141), et un canal étant défini par la plaque de recouvrement et la plaque d'appui (148) ; l'extrémité libre (20b) étant reçue de manière mobile dans le canal, et dans les processus de dépliement et de rétraction du module d'écran flexible (20), une structure partielle de l'élément mobile (63) oscillant dans le canal.

12. Dispositif électronique (100) selon la revendication 1, l'élément mobile (63) étant relié de manière rotative au second boîtier (14) et dans le processus de dépliement du module d'écran flexible (20) de l'ensemble de boîtier (10), l'élément mobile (63) étant entraîné par le module d'écran flexible (20) à tourner par rapport au second boîtier (14) pour libérer le module d'écran flexible (20) enroulé autour de l'élément mobile (63) ; et dans le processus de rétraction du module d'écran flexible (20) dans l'ensemble de boîtier (10), l'élément mobile (63) étant entraîné par l'élément élastique (61) pour rétablir l'enroulement de l'extrémité libre (20b) sur l'élément mobile (63).

13. Dispositif électronique (100) selon la revendication 1, un renfoncement de guidage (14e) étant défini dans le second boîtier (14) sur chacun des deux côtés d'une direction de déplacement du premier boîtier (12) par rapport au second boîtier (14), le renfoncement de guidage (14e) étant pourvu de manière correspondante de l'ensemble de mise en tension (60), l'ensemble de mise en tension (60) comprenant une pluralité de corps de transmission (67) disposés séquentiellement le long d'une direction d'extension du renfoncement de guidage (14e), l'extrémité libre (20b) étant disposée à une extrémité de l'ensemble de mise en tension (60), et le premier boîtier (12) étant disposé à l'autre extrémité de l'ensemble de mise en tension (60) ; dans le processus de dépliement du module d'écran flexible (20) à partir de l'ensemble de boîtier (10), la pluralité de corps de transmission (67) étant poussés par l'extrémité libre (20b) pour venir en butée les uns contre les autres de manière séquentielle et se déplacer le long du renfoncement de guidage (14e), ce qui permet à la pluralité de corps de transmission (67) de se presser contre le premier boîtier (12) ; et dans le processus de rétraction du module d'écran flexible (20) dans l'ensemble de boîtier (10), la pluralité de corps de transmission (67) étant poussés par le premier boîtier (12) pour venir en butée les uns contre les autres de manière séquentielle et se déplacer le long du renfoncement de guidage (14e), permettant à la pluralité de corps de transmission (67) de faire pression contre l'extrémité libre (20b),
de préférence, chacun de la pluralité de corps de transmission (67) étant un cylindre ou une sphère.

14. Dispositif électronique (100) selon l'une quelconque des revendications 1 à 13, le module d'écran flexible (20) comprenant :
un dispositif d'affichage flexible (21) ;
une couche de renforcement (23) empilée sur le dispositif d'affichage flexible (21) ; et
une plaque de support (25) empilée sur la couche de renforcement (23) et située sur un côté de la couche de renforcement (23) orienté à l'opposé du dispositif d'affichage flexible (21),
la plaque de support (25) comprenant une première plaque (251) reliée à l'extrémité fixe (20a) et supportée par la première surface de support (12a), et une seconde plaque (253) reliée à l'extrémité libre (20b) et à l'ensemble de mise en tension (60) et contournant l'extrémité du second boîtier (14) orientée à l'opposé du premier boîtier (12) ; et la seconde plaque (253) comprenant une pluralité de plaques de bande (253a) espacées les unes des autres, et une direction d'extension longitudinale de la pluralité de plaques de bande (253a) étant perpendiculaire à une direction de déplacement du premier boîtier (12) par rapport au second boîtier (14).
